# EUROPÄISCHE PATENTANMELDUNG

(11) **EP 4 531 223 A1**
(43) Veröffentlichungstag der Anmeldung: **02.04.2025**
(21) Anmeldenummer: 23200574.4
(22) Anmeldetag: 28.09.2023
(51) Int. Cl.: H02J 3/00, H02J 13/00, G01R 19/25

(54) **VERFAHREN ZUR BESTIMMUNG DER TOPOLOGIE EINES NIEDERSPANNUNGSNETZES**

(71) Anmelder: Siemens Aktiengesellschaft, 80333 München (DE)
(72) Erfinder: EINFALT, Alfred, 1210 Wien (AT); HAUER, Daniel, 3400 Klosterneuburg (AT)
(74) Vertreter: Siemens Patent Attorneys

(57) **Zusammenfassung**

Der vorliegenden Erfindung liegt die Aufgabe zugrunde, ein Verfahren anzugeben, das einen einfachen Beitrag zur Bestimmung der Netztopologie liefert und Massnahmen vorschlagen kann, um die Qualität der Niederspannungsnetz-Zustandsschätzung bzw. zukünftiger Topologiebestimmungen zu verbessern.

Diese Aufgabe wird erfindungsgemäss durch ein Verfahren zur Bestimmung der Topologie eines Niederspannungsnetzes und zur Bereitstellung von Massnahmen zur Verbesserung einer Zustandsschätzung für das Niederspannungsnetz gelöst, welches die folgenden Verfahrensschritte umfasst:
a) Laden eines als bekannt angenommenen Netzmodells und Ergänzen des Netzmodells mit einem gemessenen Lastprofil bzw. auf einem Lastmodell basierender Profilschätzung und einem Erzeugungsprofil bzw. auf einem Erzeugungsmodellen basierende Profilschätzung für die in dem Niederspannungsnetz vorhandenen Netzverknüpfungspunkten;
b) Durchführen von Lastflusssimulationen auf der Basis der Last- und Erzeugungsprofile bzw. -modelle, wobei die Last- und Erzeugungsprofile bzw. -modelle skaliert werden, und wobei diese Skalierung so lange erfolgt, bis vorbestimmte Abbruchkriterien erreicht sind, welche vorzugsweise über eine maximale Abweichung der Simulationswerte von vorhandenen Messdaten an einem Transformator und/oder an ausgewählten ausgewählten Messpunkten z.B. an Abgängen, definiert worden sind;
c) mit Hilfe des Simulationsverlaufs Bestimmen der dynamischen Topologie, insbesondere der Verschaltung des Netzes im Sinne von offenen oder geschlossenen Lasttrennern, bzw. auch Kabelanschlüssen bei Einschleifungen, bei der die geringsten Anpassungen an den Lasten und Erzeugern im Zuge eines mit der Simulation erzielten Load Trimmings vorgenommen worden sind;
d) optionales Definieren von mindestens einem virtuellen Messpunkt in der zuvor bestimmten Topologie, wobei Simulationsergebnisse für den virtuellen Messpunkt als geschätzte Messdaten genutzt werden; und
e) optionales Wiederholen der Schritte b) und c) für die mit dem virtuellen Messpunkt ausgestattete Topologie und Bestimmung der virtuellen Messpunkte als neue Messpunkte, wenn mit der Skalierung die vorbestimmten Abbruchkriterien erreicht werden.

Die Erfindung stellt so ein Verfahren bereit, das einerseits verifizieren kann, ob die angenommene Topologie, also die angenommene Verschaltung des Netzes, korrekt ist, und kann andererseits konkrete Messpunkte vorschlagen, um die Qualität der Niederspannungsnetz-Zustandsschätzung zu verbessern.

## Beschreibung

Die vorliegende Erfindung betrifft ein Verfahren zur Bestimmung der Topologie eines Niederspannungsnetzes und zur Bereitstellung von Massnahmen zur Verbesserung einer Zustandsschätzung für das Niederspannungsnetz.

Der klassische Netzbetrieb eines Energieverteilnetzwerks ist durch die zunehmende Durchdringung mit dezentralen, meist erneuerbaren Energieerzeugungsanlagen (DEA) vor große Herausforderungen gestellt. Hinzukommt die Entwicklung der Elektromobilität und damit eine Verstärkung der Substitution von anderen Energieübertragungsformen durch Elektrizität. Smart Grid wird, das habe die vielen unterschiedlichen Definitionen des Begriffs gemein, als Lösung für diese Problemstellung gesehen.

Um diese Änderung des Systems im Verteilnetz auch handhabbar zu machen, muss dieses daher in Zukunft ähnlich lückenlos beobachtbar sein bzw. automatisiert gesteuert werden wie ein klassisches Übertragungsnetz. Dazu werden in modernen Netzleitzentralen zunehmend spezielle Anwendungen im Distribution Management System (DMS), wie z.B. eine Distribution System State Estimation (DSSE) oder Volt/Var Control (VVC), eingesetzt. Auch wenn der praktische Einsatz in Mittelspannungsnetzen noch bei vielen Verteilnetzbetreibern in Arbeit ist, kann dies als zukünftiger Standard angesehen werden.

Aber die angelaufene Energiewende macht nicht in den Mittelspannungsnetzen halt. In einer Vielzahl von akademischen Arbeiten wurden bereits Verfahren zur Zustandsschätzung (State Estimation) für Niederspannungsnetze vorgestellt. Eine große Hoffnung wurde zunächst in die Einführung von Smart Metering Systemen gesetzt. Einerseits hat sich diese Hoffnung durch restriktive Vorgaben im Zuge des Datenschutzes zerschlagen. Andererseits entsteht mehr und mehr eine neue Situation durch die zunehmende Durchdringung mit Prosumern in den untersten Netzebenen, die:
a) Erzeugungsanlagen (heute in der Regel Fotovoltaik-Anlagen) betreiben,
b) bald auch vermehrt Speichersysteme einsetzen, und
c) sich zu Energy Communities zusammenschließen.

Zusammen mit der Einführung von Q(U) und anderer Regelungsstatiken für PV-Wechselrichter macht dies die Verwendung von entkoppelten, statischen Modellen rein aus historischen Smart Meter Daten bald obsolet.Neben diesen verbesserten Lastdaten werden sowohl zusätzliche Messpunkte als auch das Wissen über die aktuelle Netztopologie entscheidend werden.

Bis jetzt wurden, vereinfacht ausgedrückt, frühere Sicherheitsreserven des Netzes genutzt. Verteilernetze wurden vor der Liberalisierung der Verteilernetze in Europa gemäß der Prämisse einer möglichst zuverlässigen und sicheren Versorgung ausgelegt und gebaut. Die Betriebsmittel wurden für Grenzwerte ausgelegt, die es im Falle eines späteren Anschlusses weiterer Kundenanlagen ermöglichen, ohne zusätzliche Grabungs- und Baumaßnahmen auszukommen. Ein wesentlicher Planungsgrundsatz war bisher die relativ geringe Wahrscheinlichkeit des Auftretens von großen Leistungsspitzen zu gleichen Zeitpunkten. Durch diese geringen Gleichzeitigkeitsfaktoren beim herkömmlichen Verbrauch konnten viele Kunden angeschlossen werden. Insbesondere durch die sukzessive Steigerung der Elektromobilität und der damit verbundenen Ladestellen, aber auch durch Wärmepumpen kommen heute jedoch mittlere bis große Verbraucher in die Niederspannungsnetze, die sehr hohe Gleichzeitigkeiten in ihrem Lastverhalten aufweisen können.

Die "Standardlösung" ist nach wie vor der kostenintensive Ausbau des Netzes. Dies geschieht einerseits durch Verlegung zusätzlicher Leitungen oder die Installation neuer Transformatorstationen (inklusive eines Rekonfigurierens der Netztopologie).

Die zweite Möglichkeit besteht darin über Messwerte den Zustand hinsichtlich Betriebsgrenzen und der aktuellen Auslastung des Netzes zu schätzen. Wie bereits erwähnt werden in modernen Netzleitzentralen zunehmend spezielle Anwendungen im Distribution Management System (DMS) wie z.B. eine Distribution System State Estimation (DSSE) und fallweise auch schon eine Volt/Var Control (WC) eingesetzt.

Beide Anwendung arbeiten mit Last- bzw. zunehmend auch Erzeugungsmodellen für einzelne Netzknoten, an denen größere Lasten (Industriebetrieb, ...), größere Erzeuger ((Klein) wasserkraftwerk,...) und eben auch eine große Zahl von Niederspannungs (orts-)netzen angeschlossen sind.

VVC braucht natürlich auch Aktoren, wie z.B. Regelumformer im Umspannwerk, FACTS und mittelgroße Kraftwerke, sowie noch in sehr geringem Ausmaß regelbare Ortsnetztransformatoren. Ortsnetze selbst werden dabei als passive Lasten modelliert (Standardlastprofile, ggf. einfach worst case Erzeugungsprofile). Es ist zu erwarten, dass die Modelle selbst zukünftig etwas genauer werden, da anstelle von standardisierten Lastprofilen kumulierte Profile basierend auf Smart Meter Daten verfügbar sein werden. Messwerte werden bereits vereinzelt eingebunden.

Die Last- bzw. Erzeugungsmodelle für diese DSSE Anwendungen werden statisch parametriert und meist über einige ausgewählte Messpunkte skaliert. Dies wird auch als "load-trimming" bezeichnet.

Genau wie DSSE Anwendungen für Mittelspannungsnetze arbeiten auch einige der Verfahren für Niederspannungsnetze. Die Annahme besteht darin, dass in Zukunft über Smart Metering sehr genaue 15min Profile für alle Kunden (wie Eingangs beschrieben, stellt der Datenschutz in vielen Ländern ein Hindernis für diese Annahme dar) zur Verfügung stehen. Außerdem soll es intelligente Transformatorstationen geben, in denen zumindest der Lastfluss über den Transformator und bestenfalls auch aufgelöst auf einzelne Abgänge zur Verfügung stehen. Über diverse Korrelations- bzw. "Load-Trimming" Verfahren werden nun die Lasten so angepasst, dass sie zu den aktuellen Messwerten des Transformators bzw. der Abgänge passen. Das setzt ein Vertrauen in die Richtigkeit der Topologie voraus und bei komplexeren Netztopologien ergeben sich sehr viele Möglichkeiten für die Anpassung der Lasten. Eine eindeutige Lösung ist nicht möglich.

Der vorliegenden Erfindung liegt daher die Aufgabe zugrunde, ein Verfahren anzugeben, das einen einfachen Beitrag zur Bestimmung der Netztopologie liefert und Massnahmen vorschlagen kann, um die Qualität der Niederspannungsnetz-Zustandsschätzung zu verbessern.

Diese Aufgabe wird erfindungsgemäss durch ein Verfahren zur Bestimmung der Topologie eines Niederspannungsnetzes und zur Bereitstellung von Massnahmen zur Verbesserung einer Zustandsschätzung für das Niederspannungsnetz gelöst, welches die folgenden Verfahrensschritte umfasst :
a) Laden eines als bekannt angenommenen Netzmodells und Ergänzen des Netzmodells mit einem gemessenen Lastprofil bzw. auf einem Lastmodell basierender Profilschätzung und einem Erzeugungsprofil bzw. auf einem Erzeugungsmodellen basierende Profilschätzung für die in dem Niederspannungsnetz vorhandenen Netzverknüpfungspunkten;
b) Durchführen von Lastflusssimulationen auf der Basis der Last- und Erzeugungsprofile bzw. -modelle, wobei die Last- und Erzeugungsprofile bzw. -modelle skaliert werden, und wobei diese Skalierung so lange erfolgt, bis vorbestimmte Abbruchkriterien erreicht sind, welche vorzugsweise über eine maximale Abweichung der Simulationswerte von vorhandenen Messdaten an einem Transformator und/oder an ausgewählten ausgewählten Messpunkten z.B. an Abgängen, definiert worden sind;
c) mit Hilfe des Simulationsverlaufs Bestimmen der dynamischen Topologie (d.h. der Verschaltung des Netzes im Sinne von offenen oder geschlossenen Lasttrennern, bzw. auch Kabelanschlüssen bei Einschleifungen), bei der die geringsten Anpassungen an den Lasten und Erzeugern im Zuge eines mit der Simulation erzielten Load Trimmings vorgenommen worden sind;
d) Definieren von mindestens einem virtuellen Messpunkt in der zuvor bestimmten Topologie, wobei Simulationsergebnisse für den virtuellen Messpunkt als geschätzte Messdaten genutzt werden; und
e) Wiederholen der Schritte b) und c) für die mit dem virtuellen Messpunkt ausgestattete Topologie und Bestimmung der virtuellen Messpunkte als neue Messpunkte, wenn mit der Skalierung die vorbestimmten Abbruchkriterien erreicht werden.

Die Erfindung stellt so ein Verfahren bereit, das einerseits verifizieren kann, ob die angenommene Topologie, also die angenommene Verschaltung des Netzes, korrekt ist, und kann andererseits konkrete Messpunkte vorschlagen, um die Qualität der Niederspannungsnetz-Zustandsschätzung insbesondere im Bezug auf die Verifizierung des der dynamischen Topologie zu verbessern.

Weitere vorteilhafte Ausgestaltungen der vorliegenden Erfindung sind den übrigen Unteransprüchen zu entnehmen.

Bevorzugte Ausführungsbeispiele der vorliegenden Erfindung werden anhand der anhängenden Zeichnung näher erläutert. Dabei zeigen:
- Figur 1: schematisch eine Topologie mit drei Lasten und zwei realen Messpunkten;
- Figur 2: schematisch eine Topologie mit eingezeichneter Schaltstelle und zwei realen Messpunkten(a) sowie die beiden sich aus den möglichen Schalterstellungen ergebenden Topologien (b) und (c); und
- Figur 3: schematisch eine Topologie mit Schaltstelle und zwei realen Messpunkten (a) sowie zwei weitere potenzielle Topologien (b) und (c) aus dem möglichen Schalterstellungen.

Die Besonderheit der vorliegenden Erfindung liegt insbesondere darin, dass die Kenntnis über die aktuelle Verschaltung des Netzes keine zwingende Voraussetzung zur Bestimmung der Netztopologie ist, sondern die teilweise nicht 100% gegebene Aktualität erkannt und auch ggfs. gelöst wird. Der Ausbau von zusätzlicher Sensorik würde einerseits die Anschaffungs- und Installationskosten in die Höhe treiben, aber auch später laufende Aufwände im operativen Betrieb erfordern. Deswegen ist es wichtig nur in absolut notwendigen Fällen und in Netzen, die sich nicht durch reine Abgangsmessungen ausreichend schätzen lassen, zusätzliche Sensorik einzubauen. Das Verfahren ermöglicht eine effiziente Abschätzung des Netzzustandes in der untersten Verteilnetzebene und sorgt somit für eine zielgerichtete Ausbaustrategie für zusätzliche Mess-Sensorik.

Die vorliegende Erfindung weist die folgenden Merkmale auf:

### Schritt 1: Load Trimmung mit Simulationsunterstützung

Wie üblich wird ein als bekannt angenommenes Modell des Niederspannungsnetzes geladen und mit Lastprofilen bzw. Lastmodellen und Erzeugungsprofilen bzw. Erzeugungsmodellen für alle Netzverknüpfungspunkte vorbereitet. Dabei können unterschiedliche Arten von Modellen kombiniert werden, um ein möglichst gutes Einstiegsszenario zu erhalten. Dies sind zum Beispiel:
- Modelle basierend auf realen Daten (z.B. Smart Meter Daten) von ähnlichen Lasttypen, die z.B. auch mit statistischen oder geographischen Daten erweitert/ergänzt werden können
- Modelle basierend auf heterogenen Datenquellen (z.B. PV-Erzeugungsmodell basierend auf meteorologischen und geographischen Daten)
- Modelle basierend auf standardisierten Lastprofilen

Nun werden Lastflusssimulationen durchgeführt, wobei die Last- und Erzeugungsmodelle skaliert werden, die Topologie des Niederspannungsnetzes jedoch nicht verändert wird. Diese Skalierung erfolgt so lange, bis entsprechende Abbruchkriterien erreicht sind, welche in der Regel über eine maximale Abweichung der Simulationswerte von den vorhandenen Messdaten am Transformator und/oder an ausgewählten Abgängen definiert sind.

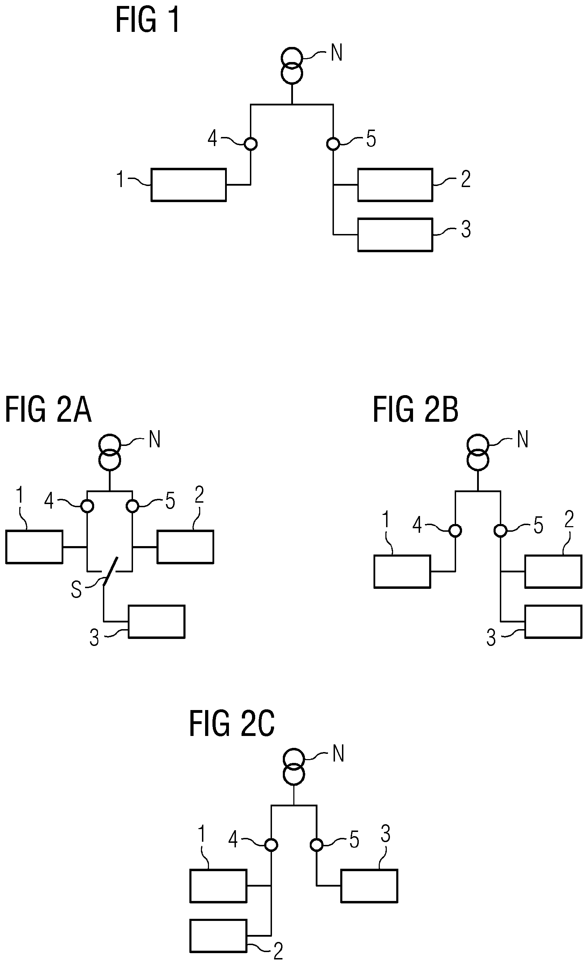

Figur 1 skizziert dies anhand eines einfachen Beispiels. Hier werden die drei Lasten 1 bis 3 (Erzeuger und/oder Verbraucher) mit Profilen hinterlegt und anschließend eine Simulation gestartet. Von vorliegend zwei dargestellten Messpunkten 4, 5 sind reale Daten bekannt. Die Profile der drei Lasten 1 bis 3 werden nun so lange modifiziert, bis die Simulationsdaten mit den realen Messdaten der beiden Messpunkte 4, 5 ausreichend genau übereinstimmen.

Im Allgemeinen gibt es hier eine Vielzahl an Profilen mit jeweils vermutlich mehreren Parametern, die unabhängig voneinander modifiziert werden können. Um die daraus resultierende Menge an potenziellen Skalierungen einzuschränken, können verschiedene Strategien verfolgt werden:
a) Gewisse Lasten bzw. Parameter können als fix angenommen werden, entweder weil reale exakte Messdaten vorhanden sind oder weil das Vertrauen in die Korrektheit der Profile vorhanden ist (z.B. gemessene Erzeugungsanlagen )
b) Minimale/Maximale Grenzwerte für verschiedene Parameter können deren Parameterraum begrenzen. Beispielsweise kann die Maximalauslastung eines Strangs die Skalierungsmöglichkeiten der angeschlossenen Lasten limitieren. Auch die Lastprofile selbst können Begrenzungen hinsichtlich der Skalierung besitzen (z.B. maximale Nennleistung von Erzeugern, Beibehaltung Profilform, etc.) .

Diese Simulationsläufe werden für alle möglichen Netztopologien, also Verschaltungen wiederholt. Theoretisch ergeben sich in komplexen Netztopologien dadurch eine Vielzahl von Möglichkeiten, die das kombinatorische Problem zu groß für eine Lösung in hinreichender Zeit machen.

Figur 2 verdeutlicht dies anhand eines einfachen Beispiels mit nur einer möglichen Verschaltung und zwei daraus resultierenden möglichen Topologien (vgl. Fig. 2(b) und Fig. 2(c)). Durch den gezielten Einsatz von domänenspezifischen Metriken, wie z.B. Schaltungen unter Last nur an Stellen mit Trennerleisten, Maximalauslastung von Kabeln usw., unternehmensspezifischen Vorgaben für Anzahl der Kunden an einzelnen Leitungen, usw. lässt sich die Zahl der Simulationsläufe auf einen eingeschränkten Satz von Alternativtopologien einschränken.

### Schritt 2: Auswertung der Load Trimming Analysen

Ist der Simulationslauf mit der zunächst angenommenen Topologie derjenige, bei dem die geringsten Anpassungen an den Lasten und Erzeugern im Zuge des Load Trimmings vorgenommen werden mussten, dann kann zu Schritt 3 übergegangen werden. Ist beispielsweise etwa die Verschaltung in Figur 2(b) diejenige, die vorab angenommen wurde, und ist für diese Topologie auch eine wesentlich geringere Skalierung der Profile der Lasten 1 bis 3 nötig als im Vergleich zur Topologie gemäss Figur 2(c), dann kann davon ausgegangen werden, dass die angenommene Verschaltung korrekt ist und die geringe Skalierung der Profile in Zukunft eine bessere Statusabschätzung liefern wird.

Liefern hingegen Simulationsläufe mit einer anderen Verschaltung ebenfalls gute Ergebnisse und ist hier eventuell auch die notwendige Skalierung der Lastprofile deutlich geringer als bei jenen Simulationsläufen mit der ursprünglich angenommenen Verschaltung, so kann dies ein Indiz für eine falsch angenommene Verschaltung sein.

Dieses Verfahren erzeugt in diesem Fall eine Meldung, damit in dem betroffenen Netzsegment (bzw. mehreren Segmenten), wo eine abweichende Verschaltung bessere/ähnlich gute Ergebnisse geliefert hat, eine Kontrolle vor Ort veranlasst wird. So kann die z.B. im GIS hinterlegte Topologie im Vergleich zur tatsächlichen Netzverschaltung geprüft werden. Erscheint der Einsatz eines Service Teams zu aufwendig, vor allem wenn der Verdacht eines fehlerhaften Topologieabbildes aufgrund der Ergebnisse nicht ausreichend begründet werden kann, so kann die Kontrolle auch indirekt über Schritt 3 erfolgen.

In Figur 2 würde dies beispielhaft bedeuten: Die Simulation ergibt für die Schaltung gemäss Figur 2(b), dass die angenommenen Profile der Lasten/Erzeuger 1 bis 3 sehr stark angepasst werden müssen, damit die simulieren Messdaten an den beiden Strängen mit den realen Messdaten übereinstimmen. Bei der Simulation der Variante gemäss Figur 2(c) fallen die notwendigen Skalierungen deutlich geringer aus. Obwohl die Variante gemäss Figur 2(b) als die korrekte aktuelle Verschaltung angenommen wurde, erzeugt die Auswertung eine Meldung, dass die Variante gemäss Figur 2(c) bessere Ergebnisse (=geringere notwendige Skalierungen) liefert. Eine Überprüfung vor Ort würde nun feststellen, dass tatsächlich die Verschaltung gemäß Figur 2(c) vorliegt und nicht wie angenommen gemäß Figur 2(b).

### Schritt 3: Vorschlag für zusätzliche Messpunkte

Es sei hier explizit angemerkt, dass dieser Schritt ein optionaler Schritt ist und auch unabhängig von den vorangehenden Schritten durchgeführt werden und somit auch als eine eigene Vorgehensweise angesehen werden kann.

Da es im Allgemeinen eine große Vielzahl an möglichen Topologie-Verschaltungen gibt, ist es trotz der genannten Methoden zur Einschränkung (siehe Schritt 1) hilfreich, gezielt neue Messpunkte in das Netzsegment einzubauen. So kann bei zukünftigen Wiederholungen dieses Verfahrens um z.B. regelmäßig die Statusabschätzung an neue Einflüsse oder Änderungen in den tatsächlichen Profilen anzupassen ein besseres bzw. schnelleres, weil weniger rechenintensives Ergebnis geliefert werden.

Dazu wird das aus Schritt 1 und 2 ermittelte Szenario, also die daraus ermittelten Skalierungen der Profile, als Ausgangslage für neue Simulationen herangezogen.

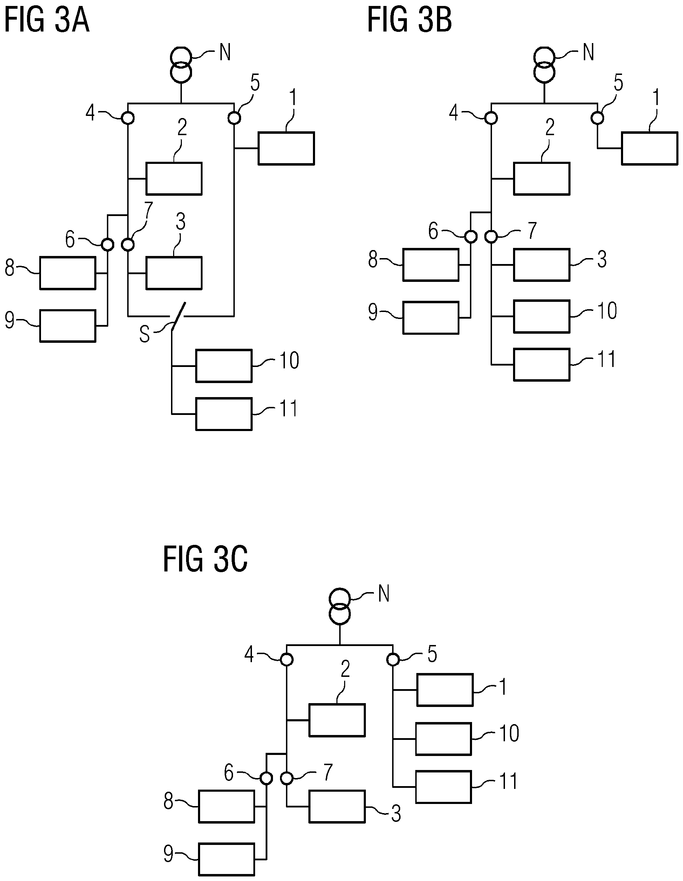

Es werden nun einer oder mehrere virtuelle Messpunkte (6, 7, vgl. Figur 3) im Netz definiert. Die Simulationsergebnisse von diesen Punkten, die z.B. in der Form von Spannungswerten am Ende eines langen Netzstranges vorliegen können, werden für die weiteren Simulationen als geschätzte Messdaten interpretiert und somit in der Simulation den realen Messdaten gleichgestellt.

Nun erfolgt wie in Schritt 1 erneut eine Simulation unter Verwendung der realen als auch der neu definierten, geschätzten Messwerte des virtuellen Messpunktes unter Anwendung des Load Trimmings bei allen Netztopologien (unter den gleichen Einschränkungen wie in Schritt 1 genannt).

An einigen Topologievarianten wird es zu einem großen Skalierungsbedarf der Last-/Erzeugungsmodelle kommen, weil die virtuellen Messpunkte ja natürlich nur bei der richtigen Topologie zutreffend sind.

Die Punkte, bei denen die verschiedenen Topologievarianten große Unterschiede bei den nötigen Skalierungen bewirken, sind daher gut geeignet, um in zukünftigen Wiederholungen des Verfahrens in der Realität die Ermittlung der tatsächlichen Verschaltung zu vereinfachen.

Ein weiteres Ergebnis dieser Analyse kann in vorteilhafter Weise auch sein, dass erkannt wird, wenn existierende Messpunkte keine gute Aussagekraft für die Topologieerkennung haben. Diese Messpunkte können von dem Verfahren dann als Messpunkte vorgeschlagen werden, die etwa auch eingespart werden können. Zur weiteren Erläuterung des Verfahrens wird auf das in Figur 3 gezeigte einfache Beispiel verwiesen. In Figur 3(a) ist ein Netz N mit zwei vorhandenen Messpunkten 4, 5 und einer Vielzahl von Lasten 1 bis 3 und 8 bis 11 (Erzeuger und/oder Verbraucher) erkennbar. Zusätzlich werden vereinfacht nur zwei virtuelle Messpunkte 6, 7 angenommen. Bei den anschließenden Simulationen der beiden möglichen Verschaltungen zeigt sich, dass die Messergebnisse beim linken Messpunkt 6 sehr ähnlich sind, wohingegen es beim rechten Messpunkt 7 nachvollziehbar klare Unterschiede gibt. Diese Unterschiede rühren daher, dass hier offensichtlich unterschiedliche Lasten in den beiden Topologievarianten folgen. Somit zeigt das Verfahren hier klar auf, dass die Position des rechten Messpunkts 7 zukünftig als hilfreicher realer Messpunkt verwendet werden könnte, die Position des linken Messpunkts 6 hingegen nicht.

Als Ergebnis von Schritt 3 wird dem Netzbetreiber also eine Liste an günstigen neuen Messpunkten vorgeschlagen, welche einen effizienten Ausbau der Sensorik und eine verbesserte zukünftige Zustandsschätzung ermöglicht. Dieses Verfahren gewinnt insbesondere dann an Bedeutung, wenn durch eine Vielzahl an möglichen Topologien und einem sehr komplexen Verhalten der Teilnehmer (mit verbrauchendem, erzeugendem und/oder speicherndem Verhalten) die notwendigen neuen Messpunkte nicht mehr durch einfache (menschliche) Analyse der Topologie ermittelt werden können.

## Patentansprüche

1. Verfahren zur Bestimmung der Topologie eines Niederspannungsnetzes und zur Bereitstellung von Massnahmen zur Verbesserung einer Zustandsschätzung für das Niederspannungsnetz, welches die folgenden Verfahrensschritte umfasst:
a) Laden eines als bekannt angenommenen Netzmodells und Ergänzen des Netzmodells mit einem gemessenen Lastprofil bzw. auf einem Lastmodell basierender Profilschätzung und einem Erzeugungsprofil bzw. auf einem Erzeugungsmodellen basierende Profilschätzung für die in dem Niederspannungsnetz vorhandenen Netzverknüpfungspunkten;
b) Durchführen von Lastflusssimulationen auf der Basis der Last- und Erzeugungsprofile bzw. -modelle, wobei die Last- und Erzeugungsprofile bzw. -modelle skaliert werden, und wobei diese Skalierung so lange erfolgt, bis vorbestimmte Abbruchkriterien erreicht sind, welche vorzugsweise über eine maximale Abweichung der Simulationswerte von vorhandenen Messdaten an einem Transformator und/oder an ausgewählten ausgewählten Messpunkten z.B. an Abgängen, definiert worden sind;
c) mit Hilfe des Simulationsverlaufs Bestimmen der dynamischen Topologie, insbesondere der Verschaltung des Netzes im Sinne von offenen oder geschlossenen Lasttrennern, bzw. auch Kabelanschlüssen bei Einschleifungen, bei der die geringsten Anpassungen an den Lasten und Erzeugern im Zuge eines mit der Simulation erzielten Load Trimmings vorgenommen worden sind;
d) optionales Definieren von mindestens einem virtuellen Messpunkt in der zuvor bestimmten Topologie, wobei Simulationsergebnisse für den virtuellen Messpunkt als geschätzte Messdaten genutzt werden; und
e) optionales Wiederholen der Schritte b) und c) für die mit dem virtuellen Messpunkt ausgestattete Topologie und Bestimmung der virtuellen Messpunkte als neue Messpunkte, wenn mit der Skalierung die vorbestimmten Abbruchkriterien erreicht werden.

2. Verfahren nach Anspruch 1,
**dadurch gekennzeichnet, dass**
sich die Wahrscheinlichkeit der Bestimmung eines virtuellen Messpunkts (6, 7) als neuer Messpunkt proportional zum Skalierungsbedarf in einer Anzahl von Topologievarianten und/oder proportional zu Abweichungen des Skalierungsbedarfs für verschiedene Topologievarianten verhält.

3. Verfahren nach Anspruch 1 oder 2,
**dadurch gekennzeichnet, dass**
anhand des Skalierungsbedarfs für Topologievarianten mit mindestens einem existierenden realen Messpunkt (4, 5) ermittelt wird, welche Aussagekraft dieser reale Messpunkt (4, 5) auf die Topologieerkennung hat.

4. Verfahren nach Anspruch 3,
**dadurch gekennzeichnet, dass**
ein realer Messpunkt (4, 5), dessen Aussagekraft für die Topologieerkennung unterhalb eines vordefinierbaren Grenzwertes für die Aussagekraft liegt, als aufzugebender Messpunkt vorgeschlagen wird.
